# EUROPEAN PATENT SPECIFICATION

(11) **EP 3 815 193 B1**
(45) Date of publication and mention of the grant of the patent: **01.11.2023**
(21) Application number: 19736465.6
(22) Date of filing: 28.06.2019
(51) Int. Cl.: H01R 12/79, H01R 12/88, H01R 12/71, H01R 12/87, A01M 1/02, A01M 31/00

(54) **ELECTRICAL CONNECTOR**
ELEKTRISCHER STECKVERBINDER
CONNECTEUR ÉLECTRIQUE

(30) Priority: 28.06.2018 GB 201810670; 25.07.2018 GB 201812109
(43) Date of publication of application: 05.05.2021
(73) Proprietor: Bare Conductive Ltd, London, Greater London E1 6LZ (GB)
(72) Inventor: DZISIEWSKI-SMITH, Stefan, London E1 6LZ (GB); HISSEY, Owen, London E1 6LZ (GB); NELSON, Bibiana, London E1 6LZ (GB)
(74) Representative: Marks & Clerk LLP
(86) International application number: PCT/GB2019/051844
(87) International publication number: WO 2020/002944

(56) References cited:
- EP-A2- 0 908 968
- DE-B4-102005 041 265
- US-A- 3 436 715
- US-A1- 2003 068 914
- US-A1- 2014 308 825
- US-B1- 7 927 110

## Description

### TECHNICAL FIELD

The present disclosure relates to electrical connectors. In particular, but without limitation, this disclosure relates to electrical connectors for connecting to electrodes printed on substrates, such as flexible substrates.

### BACKGROUND

Electrical connectors, generally, attempt to provide an electrical connection between two contacts or electrodes. Some electrical connectors include "male" and "female" connectors. A male connector is generally a component that is received within a corresponding female connector. Female connector generally has an internal cavity for receiving the male connector. The two parts may be generally configured such that the male connector may be secured within the female connector, thereby providing an electrical and mechanical connection between the two parts.

Generally, in use, the electrodes of the two parts may be urged together to ensure a reliable and consistent electrical connection. This may be achieved through providing sprung contacts. Sprung contacts may be resilient contacts, or contacts located on a resilient support structure, that may be displaced when the two parts are connected and are therefore urged against the opposing contact to maintain electrical connection.

Sprung contacts are, however, more complicated and expensive to manufacture, and more liable to being broken when compared to non-resilient or sprung contacts. For instance, to provide resilience, sprung contacts tend to be made of shaped metal that can be fixed within the connector. This means that such contacts cannot be manufactured via printing onto a substrate, such as in printed electronics (e.g. conductive ink) or etching away layers of a substrate, such as in printed circuits (e.g. etched PBCs).

Recent developments in printed electronics allow electronic circuits to be formed quickly and inexpensively, for instance by printing using conductive ink. Such circuits may be printed onto not only rigid substrates but also flexible substrates (for instance, paper or cardboard). This allows inexpensive, disposable circuits to be manufactured.

Having said this, such circuits can be difficult to connect to as the contacts on such circuits will inherently be non-resilient. Furthermore, contacts printed using conductive ink may be prone to being worn off of the substrate if repeatedly connected and disconnected. Equally, flexible substrates may be prone to buckling as they are inserted into a connector.

There is therefore a need for a simple and effective method for connecting to flat, non-resilient contacts, such as those printed onto a substrate.

US 3,436,715 discloses a connector for a printed circuit, wherein portions of the printed circuit are exposed on a board to which a frame is secured.

US 2014/0308825 A1 discloses a connector comprising a plurality of contact which are formed using a plurality of conductive contact points provided on a first plate surface of an FPC as a connection object, a frame member which an opening size and a height capable of receiving a mating connector and is attached to the first plate surface of the FPC so as to surround the contacts, and a plate-like member which is provided on a second plate surface of the FPC so as to extend over a region corresponding to the contacts.

US 7,927,110 B1 discloses a connector clip adapted for holding a flat cable directly against a printed circuit board (PCB) including a pair of vertical walls mounted on the PCT with a width same to the flat cable, a pair of horizontal walls extending inwards from the vertical walls to commonly define a receiving room to receive the flat cable with a front opening from which the flat cable is inserted and a pressing cover disposed between the pair of horizontal walls in a horizontal plane.

EP 0908968 A2 discloses a female connector adapted for electrically interconnecting the conductors of a flat flexible circuit to the conductors of a complementary mating connecting device.

US 2003/0068914 A1 discloses a connector comprising a lower portion having an electrode end and an ECG end, and an upper portion pivotally connected to the lower portion.

DE 10 2005 041265 B4 discloses a connector system comprising a male connector and a female connector which comprises a holding frame on a substrate. The connection is secured by resilient prongs situated within the holding frame, maintaining the male connector in the frame.

### SUMMARY

According to a first aspect there is provided an electrical connector system for providing an electrical connection between a first electrode and a second electrode printed onto a substrate, the system comprising a male connector comprising the first electrode located proximal to a first end of the male connector and a female connector comprising a coupling portion forming a cavity with an opening into which the first end of the male connector may be received, the coupling portion having one or more biasing surfaces that each oppose a base of the female connector. The electrical connector system is configured such that when the male connector is urged into the coupling portion, the first electrode is urged towards the base of the female connector by the one or more biasing surfaces to form an electrical connection between the first electrode and the second electrode positioned between the base and the first end of the male connector. The female connector further comprises a housing formed by sidewalls and a rear wall into which the male connector is to be received, wherein: the rear wall opposes the coupling portion; and each side wall is connected to the rear wall at corresponding corners. A distance between the coupling portion and the rear wall is substantially the same as a length of the male connector from the first end of the male connector to a second end of the male connector that is opposite to the first end. The system is configured such that the first electrode is urged towards the base of the female connector in response to the first end of the male connector being inserted into the coupling portion at an angle to the base of the female connector and being rotated towards the base of the female connector.

Accordingly, embodiments of the invention provide a simple and effective method of mechanically and electrically connecting to a printed electrode. The electrode may either be printed onto a substrate that can be inserted between the base and the first electrode, or the electrode may be printed onto the base itself.

The system comprises two separate parts, a first part (male connector) and second part (female connector). The descriptors "male" and "female" relate to how the male connector is received within the female connector, and do not necessarily relate in any way to the direction of power/electricity transfer.

The coupling portion may comprise one or more receiving means that may be in the form of one or more jaws. The one or more biasing surfaces need not directly oppose the base of the female connector as there may be a transverse displacement between the base and the one or more biasing surfaces. The one or more biasing surfaces oppose the base in that they face towards the plane along which the base lies (and vice versa).

According to an embodiment each of the one or more biasing surfaces is angled relative to the base such that the internal height of the cavity decreases from the opening towards a rear portion of the cavity. This provides the means for at least some of the biasing force to clamp the first against the second electrode as the male connector is urged into the cavity. The biasing surface angle need not be straight, but could be curved, provided that the internal height of the cavity decreases. The angled biasing surface may form the cavity at least partly into a wedge-shape.

According to an embodiment the female connector comprises a substrate receiving section configured to receive the substrate upon which the second electrode is printed and wherein the system is configured to clamp the substrate between the base and the first electrode when the male connector is urged into the coupling portion.

According to an embodiment the receiving section comprises a substrate holder that is configured to receive and hold the substrate in an interference fit prior to the male connector being received into the female connector. The substrate holder may have an internal height that is less than the thickness of the substrate to enable the interference fit. The interference fit may be between an upper lip of the substrate holder and the base of the female connector.

The base may slope downwards (may decrease in thickness) from an entrance to substrate holder. This can help guide the substrate into position.

According to an embodiment the second electrode is incorporated into a flexible strip for insertion between the base and the first electrode. Accordingly, the system may be configured to connect to an electrode printed onto a flexible substrate. Such an electrode cannot provide its own biasing force. The clamping force provided by the system therefore enables a secure connection to the flexible substrate. Furthermore, where the clamping force is provided by a rotational motion, as shall be described later, the rotational motion can avoid the flexible substrate from buckling.

According to an embodiment the base forms part of the substrate and the second electrode is printed onto the base. Accordingly, the second electrode may be integrated into the female connector.

According to a further embodiment the coupling portion is resilient and configured to be deflected at least partially when the first end is urged into the coupling portion thereby urging the first electrode against the base of the female connector. This provides additional clamping action to provide an improved connection.

According to an embodiment the female connector comprises a releasable locking mechanism configured to releasably secure the male connector into position in the female connector once the male connector has been urged into the coupling portion to secure the first electrode against the second electrode.

According to an embodiment, for at least a portion of the cavity, the internal height of the cavity is less than a thickness of the first end of the male connector.

According to the invention the female connector comprises a housing including a rear wall that opposes the coupling portion, wherein a distance between the coupling portion and the wall is substantially the same as a length of the male connector from the first end of the male connector to a second end of the male connector that is opposite to the first end, and wherein the system is configured such that the first electrode is urged towards the base of the female connector in response to the first end of the male connector being inserted into the coupling portion at an angle to the base of the female connector and being rotated towards the base of the female connector.

The rotational action reduces wear on the electrodes and, where the substrate is a flexible substrate, avoids the substrate buckling as the male connector is urged into the female connector. The wall of the housing provides resistance against the male connector leaving the cavity once fully inserted. Accordingly, the wall at least partly secures the male connector in place. The male connector may fit between the wall and the coupling portion by means of an interference fit.

According to an embodiment the male connector comprises a sloped rear wall located at the second end of the male connector and configured to contact the wall of the female connector when the male connector is rotated towards the base of the female connector to urge the male connector further into the coupling portion. The first electrode may be located on a base, or underside, of the male connector and the sloped rear wall may form an obtuse angle with the base of the male connector. The sloped wall allows the male connector to be urged gradually further into the coupling portion as it is rotated. Furthermore, the sloped wall provides some clearance to allow the second end of the male connector to pass the top of the wall as the male connector is rotated into position.

According to an embodiment the first electrode of the male connector may comprise two surfaces joined by an edge that is configured to contact the second electrode as the male connector is urged into the coupling portion. The edge may slide along the second electrode as the male connector is rotated towards the base. The first electrode may form a contact around the edge of a rigid substrate of the male connector.

According to an embodiment the first electrode is formed on a printed circuit board (PCB) housed within the male connector and exposed at least at the first electrode. The male connector may therefore provide housing support for the PCB to avoid the PCB from breaking as the two electrodes are urged together. The first electrode may form a contact around the edge of the PCB. The system has the advantage that two flat, non-sprung (non-resilient) electrodes may be connected together simply via a connection system that is easy to use and simple and inexpensive to manufacture.

The male connector may comprise a plurality of first electrodes formed on the printed circuit board, proximal to the first end of the male connector, wherein solder resist is removed from between the contacts to improve connection with one or more corresponding second electrodes positioned between the base and the first end of the male connector. This avoids the risk of the solder resist protruding above the first and preventing contact with the one or more second electrodes.

According to an embodiment the male connector comprises one or more indentations for receiving one or more protrusions from the coupling portion. This helps guide the male connector into place and provides one or more pivot points about which the male connector may be rotated. Each of the one or more indentations may have a base the slops downwards, towards the first end of the male connector. This profile may match the sloping of the one or more biasing surfaces. The male connector according to the invention comprises a first electrode located proximal to a first end of the male connector.

According to an embodiment the electrode is located on a base of the male connector and wherein the male connector further comprises a sloped rear wall located at a second end of the male connector that is opposite to the first end, the sloped rear wall forming an obtuse angle with the base of the male connector.

The rear wall may be configured to contact the (rear) wall of the female connector when the male connector is rotated towards the base of the female connector to urge the male connector further into the coupling portion.

According to an embodiment the male connector comprises an upper side, opposite to the base, wherein one or more indents are formed at the first end of the upper side and are configured to engage with one or more protrusions from a corresponding female connector into which the male connector is configured to be inserted. Each protrusion may be a tip or end of the lip of a cavity into which the male connector may be urged. According to an embodiment the base of each of the one or more indentations slopes downwards towards the first end of the male connector.

According to an embodiment the first electrode of the male connector comprises two surfaces joined by an edge.

According to an embodiment the first electrode is connected to circuitry formed on a printed circuit board housed within the male connector and exposed at least at the first electrode.

According to an embodiment the male connector comprises a plurality of first electrodes formed on the printed circuit board, proximal to the first end of the male connector, wherein solder resist is removed from between the contacts to improve connection with one or more corresponding second electrodes positioned between the base and the first end of the male connector.

Further embodiments are described below.

According to the invention there is provided an electrical connector system according to claim 1.

The substrate may form part of the electrical connector system, or may be an external part that is inserted into the electrical connector system. For instance, the electrode may be printed directly onto the base of the female connector of the electrical connector system. That is, the substrate may comprise the base or vice versa.

The electrical connector system may be for connecting to a flat, non-sprung electrode such as one printed or otherwise deposited onto flexible substrate.

Alternatively, the substrate may be secured within the electrical connector system between the male and female connector, e.g. via a pinning or clamping action.

According to an embodiment the female connector comprises a substrate receiving section configured to receive the substrate and wherein the system is configured to secure the substrate against the base when the male connector is urged into the one or more receiving means.

According to an embodiment the receiving section comprises a substrate holder that is configured to that receive the substrate in an interference fit prior to the male connector being fitted into the female connector.

According to an embodiment the system is configured to connect to an electrode printed onto a flexible substrate.

According to an embodiment the second electrode is be incorporated into a flexible strip for insertion between the base and the first electrode.

According to an embodiment the base forms part of the substrate and wherein the second electrode is printed onto the base.

According to an embodiment each of the one or more receiving means is resilient and configured to be deflected at least partially when the first end is urged into the one or more receiving means thereby urging the first electrode against the base of the female connector.

The resilience can provide a securing/connecting force to pin/clamp/squeeze the first connector against the second connector. The receiving means may be jaws. The one or more jaws may be resilient. This allows the one or more jaws to flex as the first end is urged into the jaw, thereby urging the first portion against the second portion. Having said this, the receiving means need not be resilient, and could instead be rigid. According to an embodiment, for each of the one or more receiving means, the cavity is formed as a wedge-shaped cavity.

According to an embodiment the female connector comprises a releasable locking mechanism configured to releasably secure the male connector into position on the female connector once the male connector has been urged into the one or more receiving means to secure the first contact against the second contact.

According to the invention the female connector comprises a housing including a wall that opposes the one or more receiving means, wherein a distance between the one or more receiving means and the wall is substantially the same as a length of the male connector from the first end of the male connector to a second end of the male connector, and wherein the system is configured such that the first electrode is urged towards the base of the female connector in response to the first end of the male connector being inserted into the one or more receiving means at an angle to the base of the female connector and being rotated towards the base of the female connector.

According to an embodiment the first electrode of the male connector comprises two surfaces joined by an edge.

According to an embodiment the first electrode forms a contact around the edge of a rigid substrate of the male connector.

According to an embodiment the rigid substrate is a circuit board housed within the male connector and exposed at least at the first electrode.

According to an embodiment the male connector comprises one or more indentations corresponding to the one or more receiving means, the one or more indentations being configured to receive at least part of a corresponding receiving means.

Urging the male connector into the one or more receiving means comprises inserting the first end of the male connector into the one or more receiving means at an angle to the surface of the female connector, and rotating the male connector towards the surface of the female connector.

The male connector may comprise a casing for electronic components connected to the first electrode. The casing may be mechanically secured to the female connector via an interference fit between the one or more jaws and an opposing structure (e.g. an opposing wall) or a catch/latch mechanism.

The male connector may have a sloped wall proximal to a second end that is opposite to the first end, the sloped wall being configured such that the male connector is urged into the one or more jaws as the second end is rotated/urged against an opposing wall/member of the female connector, the opposing wall/member opposing the one or more jaws.

The male connector may have one or more indentations for receiving the one or more receiving means/jaws. Each indentation may be sloped similarly to the corresponding biasing surface. Accordingly, the one or more indentations may have sloped walls and may be configured to urge the first end towards the surface of the female connector as the first end is urged into the jaws/as the one or more sloped walls of the one or more indentations are urged against the corresponding one or more jaws.

The first end of male connector may comprise a protrusion comprising the first electrode. The first electrode may be formed over a corner/edge of the protrusion.

The male connector may comprise a plurality of electrodes. Equally, the substrate may comprise a plurality of electrodes.

### BRIEF DESCRIPTION OF THE DRAWINGS

Arrangements of the present invention will be understood and appreciated more fully from the following detailed description, made by way of example only and taken in conjunction with drawings in which:
Fig. 1 shows a connector system according to an embodiment in assembled form;
Fig. 1B shows a top-down view of the inside of the outer housing of Fig. 1A;
Fig. 2 shows cross-sectional, underside, side, top, front and rear views of the outer housing of Fig. 1A;
Fig. 3 shows the inner housing of Fig. 1A via cross-sectional, underside, side, top, front and rear views;
Fig. 4 shows a perspective view and front and side cross-sectional views of the contacts of the PCB mounted within the inner housing of Fig. 1A;
Fig. 5 shows a top-down view of the outer housing and substrate both before (top) and after (bottom) the substrate has been inserted into the outer housing;

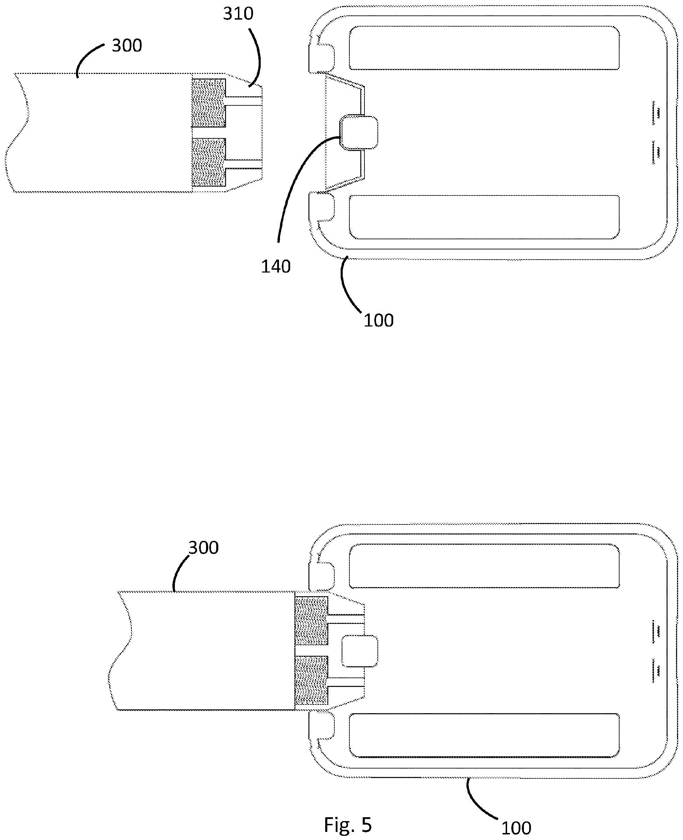

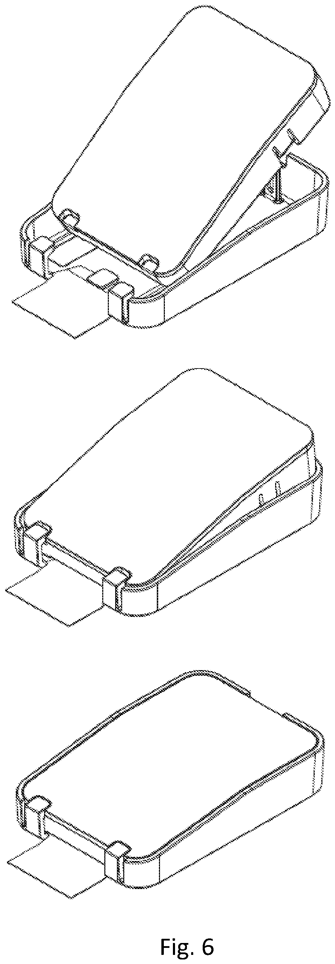

Figs. 5 and 6 show how the inner housing may be mounted within the outer housing to provide a mechanical and electrical connection between the contacts of the inner housing and the contacts of the substrate; and

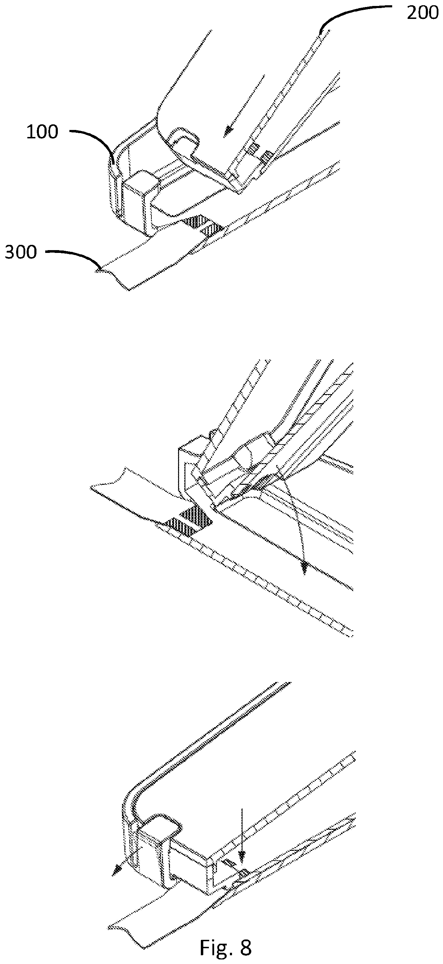

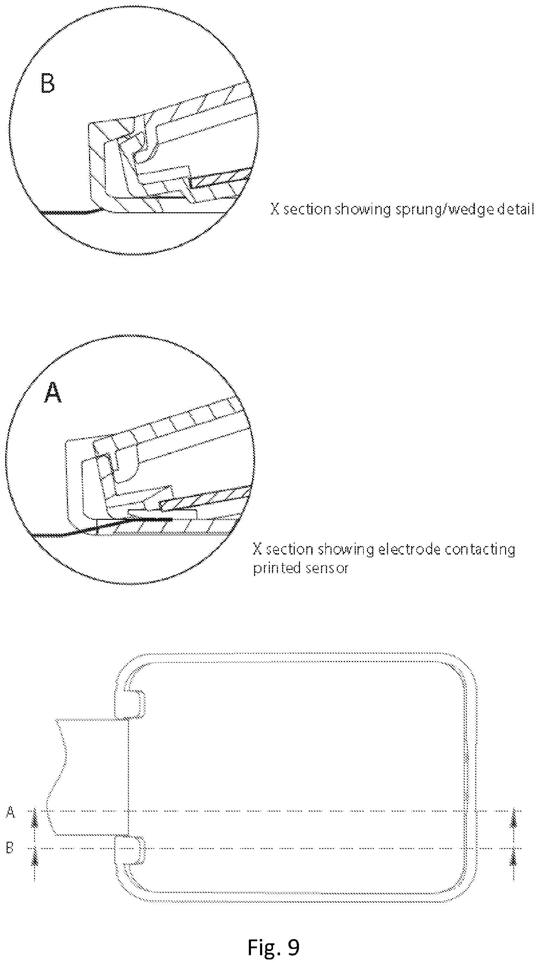

Figs. 8 and 9 show magnified cross-sectional views of the inner and outer housings as the system is rotated closed.

### DETAILED DESCRIPTION

The general function of various embodiments shall be described first before specific embodiments are described with reference to the figures.

According to the invention the connector system comprises a first part (a male connector, an inner container or housing) that is configured to be received in a second part (a female connector, an outer container or housing) and a substrate having an electrode on it. The inner container may be received in the outer container. The substrate may be inserted into a substrate holder in the inner container. The substrate may be held in the substrate holder via an interference fit.

The inner container has an electrode at a first end of the inner container. The outer container has receiving means in the form of two jaws. The two jaws are configured to receive the first end. The substrate holder is located on a base of the outer container, in between the two jaws.

The inner container may be a PCB holder that contains a PCB or any other form of electronic circuitry. The electrode on the PCB holder allows an electrical connection to be made between the electrode on the substrate and the electronic circuitry.

When inserted into the substrate holder the substrate may be pinned to the base of the outer container by the electrode of the inner container. That is, as the inner container is urged or pushed into the receiving means, the electrode of the inner container is urged against the electrode of the substrate to form electrical connection and to mechanically secure the substrate in position by pinning the substrate against the base.

The electrical connector system works via a pivoting motion. The inner container may be inserted into the jaws at an angle to the base and then rotated towards the base of the outer container. The jaws have a sloped internal upper face that opposes the base of the outer container. As the inner container rotates towards the base of the outer container, the electrode of the inner container is moved towards the electrode of the substrate and urged against the electrode of the substrate to pin the substrate against the base of the outer container.

An opposing wall is located opposite the jaws of the outer container. The inner container has a sloped base that ensures that as the inner container is rotated towards the base of the outer container, the sloped base is urged against the opposing wall and the opposing wall thereby urges the inner container further into the jaws of the outer container.

The inner container may be secured into position within the housing of the outer container by releasable locking mechanism that may be released, for instance, via the use of a key.

The electrode on the substrate may be printed onto the substrate via electronic ink. Further tracks of electronic ink may be formed on the exposed surface of the substrate to act as a sensor, for instance a pest sensor. For instance, dropping from a pest, such as a bedbug, may be detected by a short circuit between the tracks.

The pivoting action for connecting to the printed substrate reduces the wear on the substrate thereby reducing the risk of rubbing away electronic ink from the surface of the substrate over repeated uses.

The electrode of the inner container may be printed around the edge and side of a board (such as the PCB) to improve contact at the board edge and to allow a good contact via the rotational camming action. The PCB may be secured to the inside of the inner container.

Whilst the above embodiments describe a connector system for connecting to the flexible substrate, the substrate may equally be rigid. Furthermore the substrate may not necessarily be received into the outer container, instead outer container may be attached to or form part of the substrate.

For instance, an electrode may be printed directly onto the base of the outer container, with the outer container acting as a means for connecting the electrode of the inner container to the electrode of the outer container.

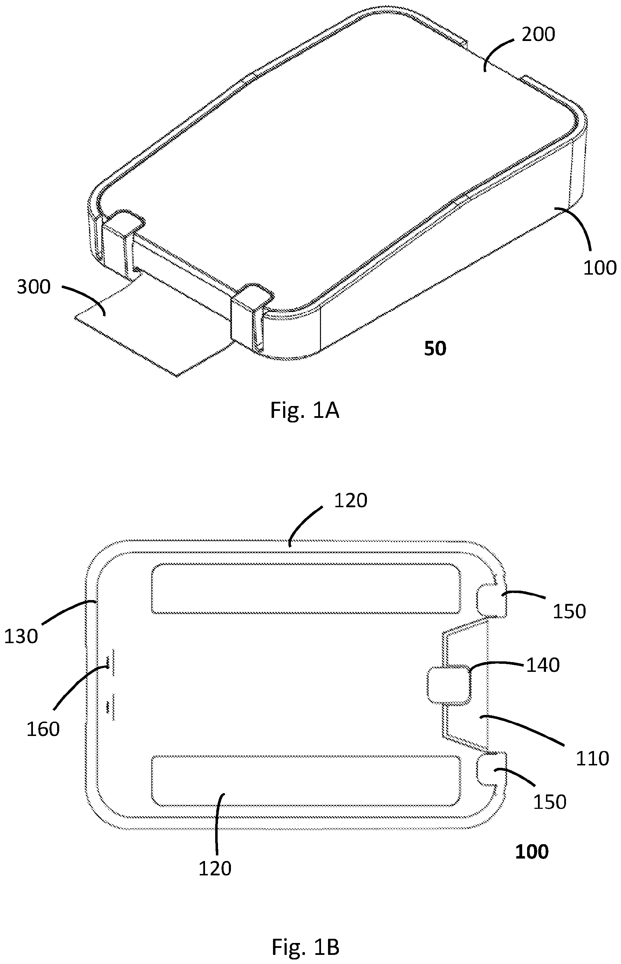

Fig. 1A shows an electrical connector system 50 according to an embodiment in assembled form. The electrical connector system 50 comprises an outer housing 100 and an inner housing 200.

The electrical connector system 50 is configured to mechanically and electrically connect to a substrate 300. The inner housing 200 is configured to be received within the outer housing 100. The interaction between the inner housing 200 and outer housing 100 causes the substrate 300 to be secured within the system 50.

The inner housing 200 comprises at least one electrode that is urged against an electrode on the substrate 300 when the inner housing 200 is received within the outer housing 100.

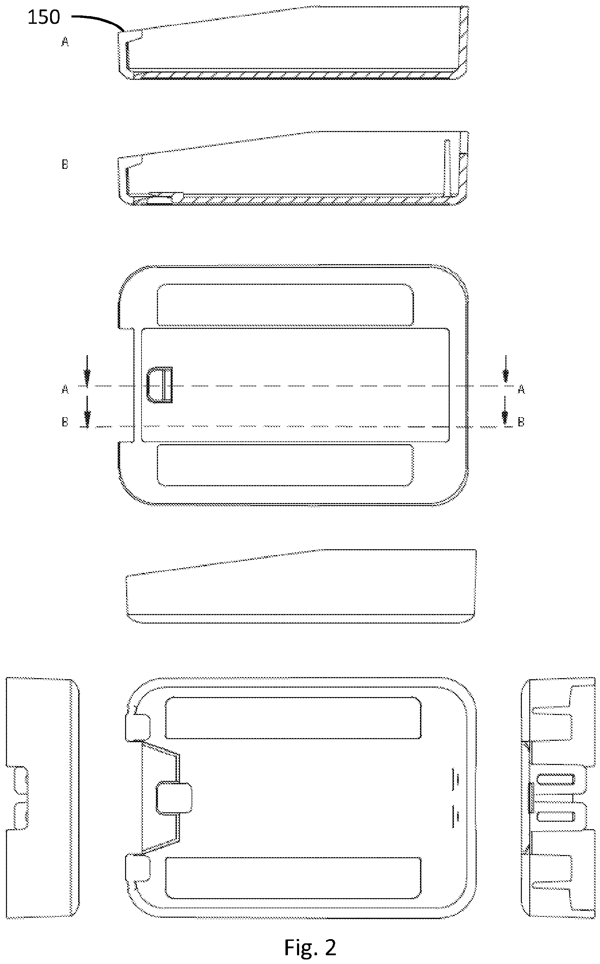

Fig. 1B shows a top-down view of the inside of the outer housing 100 of Fig. 1A. Furthermore, Fig. 2 shows cross-sectional, underside, side, top, front and rear views of the outer housing of Fig. 1A. The planes through which the cross sections are taken are indicated via dashed lines A and B.

The outer housing 100 comprises a flat base 110, opposing sidewalls 120 and a rear wall 130. The sidewalls 120 and rear wall 130 protrude from the edges of the base 110, perpendicular to the base 110. The sidewalls 120 are located along longitudinal edges of the base 110 and the rear wall 130 is located on a transverse edge at a rear, or distal, end of the outer housing 100. Each side wall 120 is connected to the rear wall 130 at corresponding corners. The base 110, sidewalls 120 and rear wall 130 form a cavity into which the inner housing 100 may be received. The base 110 has two longitudinal cutouts that run along the length of the outer housing 100, adjacent to the sidewalls 110, and spaced away from the central longitudinal axis of the outer housing 100.

A coupling section is located at a forward, or proximal, end of the outer housing 100 (at an opposite end to the rear end). The coupling section comprises a substrate holder 140 and two jaws 150 that protrude from the base 110 of the outer housing 100, perpendicular to the base 110. The jaws are spaced apart forming an opening such that the substrate 300 may be inserted between the jaws 115, into the substrate holder 140.

The substrate holder 140 forms a cavity into which the substrate 300 may be received and secured within the substrate holder 140 by means of an interference fit between the substrate holder 140 and the base 110.

The jaws 150 are means for receiving and securing the inner housing 200 against a substrate received within the substrate holder 140. The jaws 150 form a cavity into which the front end of the inner housing 200 may be received. Each jaw has a sloped upper face that opposes the base 110 of the outer housing 100. The sloped upper face means that the internal height of each jaw 115 decreases from an entrance of the jaw 115 back to the rear of the jaw 115.

The decreasing internal height of the jaws 115 serves to urge the front of the inner housing 200 downwards, against the base 110 of the outer housing 100, when the front of the inner housing 200 is urged into the jaws 115. This provides a clamping force that serves to ensure that there is a strong connection between the contacts of the inner housing 200 and the contacts of the substrate 300. Furthermore, this clamping action serves to secure the substrate 300 within the connector system 50.

A locking mechanism 160 protrudes from the base 110 towards the rear end of the base 110. The locking mechanism 160 is configured to releasably engage with a corresponding locking mechanism in the inner housing 200 to lock the inner housing 200 in place within the outer housing 100 when the inner housing 100 is fully inserted into the outer housing 100.

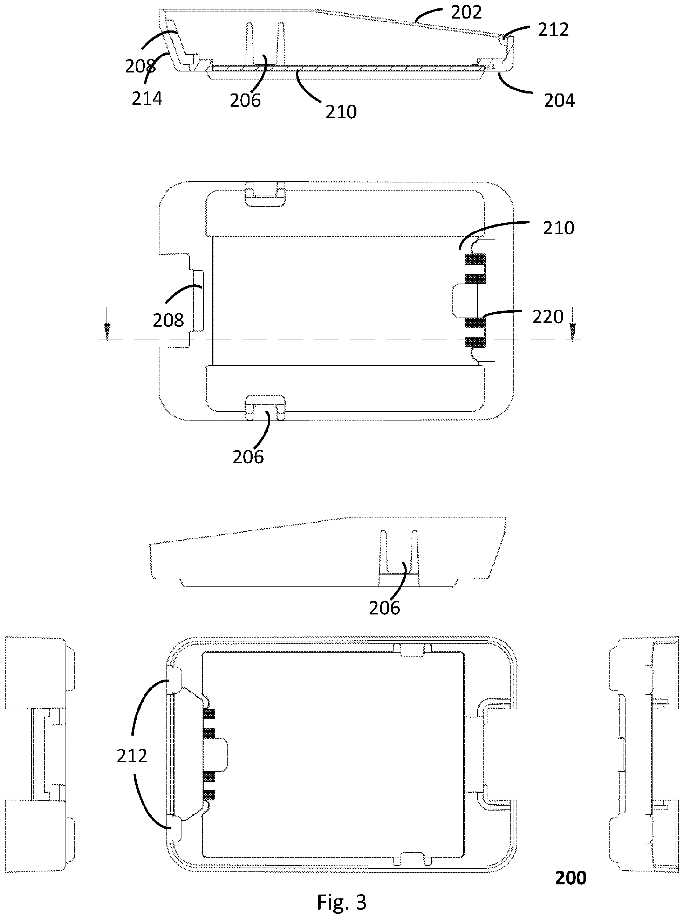

Fig. 3 shows the inner housing 200 of Fig. 1A via cross-sectional, underside, side, top, front and rear views. The plane through which the cross section is taken is indicated via a dashed line.

The inner housing 200 comprises a casing that is formed of two parts, an upper part 202 (or lid) and a lower part 204. These form a case or housing for a printed circuit board (PCB) 210. The inner housing 200 is therefore a PCB holder. The front, rear and top views (the bottom three views) show only the lower part 204 of the inner housing 200. Accordingly, the PCB can be seen in the top view, although this would be covered once the upper part 202 was secured over the top of the lower part 204.

The lower part 204 forms a cavity into which the PCB 210 may be lowered to lie flat on a base of the lower part 204. The PCB 210 can be secured in place via clips 206 located in sidewalls of the lower part 204. Each clip 206 protrudes into the cavity and is resilient such that it may be displaced outwards as the PCB 210 is inserted into the cavity. Once the PCB 210 is fully inserted, such that it lies flat against the base of the lower part 204, the clips 206 spring back into their original position to lock the PCB 210 into place. Each clip 206 can therefore be considered a latch.

The PCB 210 sits within a recess in the base of the lower part 204 to prevent the PCB 210 from moving around once locked into position. Once the PCB 210 is secured within the lower part 204, the upper part 202 may be locked into position over the lower part 204 to enclose the PCB 210. A clip is provided at the rear of the upper part 202 for engaging with the lower part 204 to lock the upper part 202 in place on the lower part 204.

The base of the lower part 202 comprises a cutout for exposing a portion of the underside of the PCB 210 when the PCB is secured within the inner housing 200.

The PCB 210 comprises contacts 220 (or electrodes) on the underside of the PCB 210 at a proximal (near) edge of the PCB 210. The contacts 220 are located on rectangular tabs protruding from the proximal edge of the PCB 210, in the plane of the PCB 210. Two contacts 220 are located on each of the two tabs. The inner housing 200 encases the PCB 220 with the exception of the cutout on the underside of the inner housing 210 which exposes the PCB 220, and in particular exposes the contacts 220. The tabs of the PCB 220 slot underneath the underside of the lower part 204. This provides support for the contacts 220 when urged against the contacts of the substrate 300.

The lower part 204 comprises a locking mechanism 208 that is configured to engage with a corresponding locking mechanism 160 of the outer housing 100 to lock the inner housing 200 in place within the outer housing 100.

Two recesses 212 are located at upper front edge of the inner housing 200, that is, at the proximal end of the inner housing 200 on the top of the inner housing 200. The recesses are arranged such that the jaws 150 of the outer housing 100 may be received within, and engage with, the recesses 212. Each recess 212 has a lower surface that slopes downwards towards the proximal end of the inner housing 200. That is, the depth of each recess 212 increases towards the proximal end of the inner housing 200.

The lower part 204 comprises a rear wall 214 that is located at the distal end of the lower parts 204, that is, at the opposite end to the two recesses 212. The rear wall 214 slopes outwards from the base of the lower part 210. The sloping of the rear wall 214 provides a means for urging the inner housing 200 forward, against the jaws 115 of the outer housing 100, when the inner housing 200 is inserted into the outer housing 100.

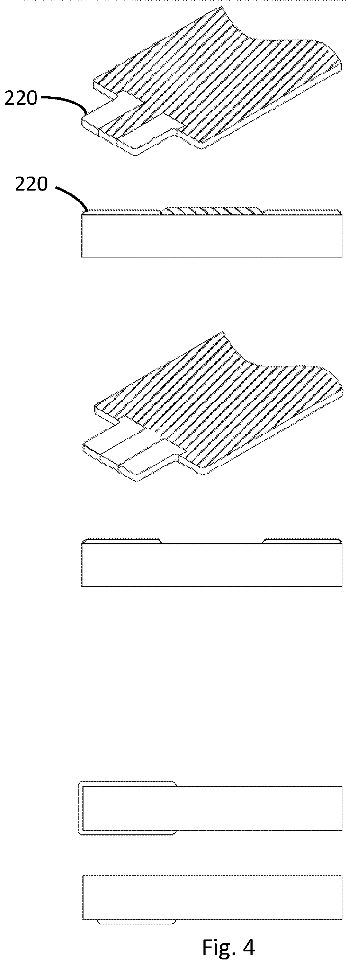

Fig. 4 shows a perspective view and front and side cross-sectional views of the contacts of the PCB 220 mounted within the inner housing 200 of Fig. 1A.

As discussed with reference to Fig. 3, the contacts 220 are located on tabs that protrude from the end of the PCB 210. Two contacts 220 are located on each tab.

In the present embodiment the contacts 220 are exposed by etching away a solder resist (shown with cross-hatching in Fig. 4) that forms an upper resistive layer. To ensure an effective connection between the contacts 220 of the PCB 210 and the contacts 310 of the substrate 300, the solder resist between the contacts 220 is also etched away. This can be seen in the middle cross-sectional view shown in Fig. 4. Removing solder resist from between the contacts 220 provides an improved connection as there is no chance of solder resist rising above the contacts 220 and preventing connection with the contacts 310 on the substrate 300.

To further improve the connection, the contacts 220 are wrapped around the edge of the PCB 210. Each contact 220 wraps around the front and side faces of the respective tab, and around to the underside of the tab (see bottom of Fig. 4). Edge plating around the side of the PCB 210 helps in two ways. Firstly, it ensures that the conductive electrode extends all the way to the edge of the PCB 210, improving contact by having no "dead" zone at the board edge that may contact the substrate 300 first and impede contact with the conductive electrode. Secondly, if the connection is made by rotationally "camming down" onto the substrate 300, then it creates a conductive corner which is locally sharp and ensures good contact.

Fig. 5 shows a top-down view of the outer housing 100 and substrate 300 both before (top) and after (bottom) the substrate 300 has been inserted into the outer housing 100.

The substrate 300 has contacts printed onto one side of a proximal end of the substrate 300. The contacts 310 may be formed from conductive ink printed onto the substrate 300. Alternatively, the contacts may form part of the substrate 300 and may be exposed via etching. The contacts 310 may be connected to interwoven or interdigitated conductive tracks for the detection of pests. For instance, a pest may be detected when the tracks are short-circuited via droppings from the pest. In Fig. 5 the tracks are hidden by a cover; however, in use, the tracks would be exposed.

The substrate 300 may be flexible and may be manufactured using inexpensive materials. This means that the substrate may be cut down to size to fit a particular use case and may be discarded and replaced relatively inexpensively. In the present embodiment the substrate 300 is made from card.

To secure the substrate 300 within the connector system 50, the substrate 300 is first inserted into the substrate holder 140. This happens when the outer housing 100 has been separated from the inner housing 200. That is, this occurs before the inner housing 200 is mounted within the outer housing 100.

The base 110 of the outer housing 100 becomes thinner towards the proximal edge of the outer housing 100. This forms a ramp that leads to the substrate holder 140 to help guide the substrate 300 into the substrate holder 140.

The substrate holder 140 is raised jaw that has an internal height that is smaller than the thickness of the substrate 300. The substrate holder 140 holds the substrate 300 in place via an interference fit. That is, the substrate holder 140 urges the substrate 300 against the base 110 of the outer housing 100. The base 110 is cut away underneath the substrate holder 140 to allow the substrate 300 to flex downwards when the substrate 300 is inserted into the substrate holder 140.

Figs. 5 and 6 show how the inner housing 100 may be mounted within the outer housing 200 to provide a mechanical and electrical connection between the contacts 220 of the inner housing 100 and the contacts 310 of the substrate 300.

The substrate 300 is mechanically secured within the system 50 and electrically connected to the system 50 via a pinching or pinning action. The pinching action is provided as the inner housing 200 is urged into the jaws 150 outer housing 100 at an angle and rotated into position flat against the base of the outer housing 100.

As shown at the top of Fig. 6, the proximal end of the inner housing 200 is inserted into the jaws 150 of the outer housing 100 when the substrate 300 is held in the substrate holder 140. Inner housing 200 is inserted into the jaws 150 at an angle to the base 110 of the outer housing 100. The tip of each jaw 150 is received within a corresponding recess 212 in the top edge of the inner housing 200.

The pinching action caused by the system allows the electrical connector system 50 to connect to a flat, non-sprung (non-resilient) electrode such as one printed on to a flat substrate. Furthermore, the rotating action avoids wear on the electrodes through repeated opening and closing of the system 50. In addition, the rotating and pinching action allows the system 50 to connect to an electrode on a flexible substrate without risking the substrate buckling as the system 50 is closed.

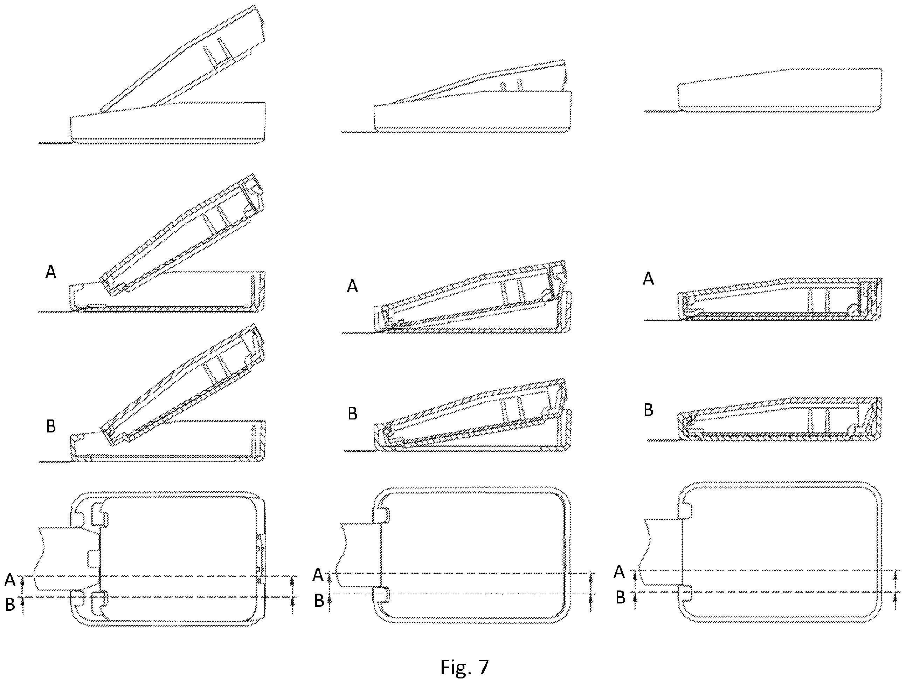

As can be seen in Fig. 7, the sloped rear wall 214 of the inner housing 200 provides a means for urging the front of the inner housing 200 further into the jaws 115 as the inner housing 200 is rotated into the outer housing 100. This is via the sloped rear wall 214 of the inner housing 200 contacting the rear wall 130 of the outer housing 100. Accordingly, as the inner housing 200 is rotated into the outer housing 100, the front of the inner housing 200 is urged further into the jaws 115 as the rear wall 130 of the outer housing 100 slides up the sloped rear wall 214 of the inner housing 200. The inner housing 200 is at least partially secured within the outer housing 100 via an interference fit between the jaws 115 and the rear wall 130 of the outer housing 100.

Figs. 8 and 9 show magnified cross-sectional views of the inner 200 and outer 100 housings as the system is rotated closed. The jaws 115 are formed of resilient material. They therefore provide a spring action to further urge the inner housing 200 towards the base 110 of the outer housing 100 to clamp system around the substrate 300.

When fully inserted into the outer housing, the height of the front end of the inner housing 200 is slightly larger than the internal height of each jaw 115. This causes the jaws 115 to flex outwards slightly as the inner housing 200 is rotated towards the base 110 of the outer housing 100. In the present embodiment, the outer housing 100 is formed of moulded plastic that is resilient to flexing. Accordingly, the jaws 115 apply a resistive force to oppose the flexing. This provides additional clamping force to further improve the mechanical and electrical connection between the two sets of contacts.

The embodiments described above make use of the rotational camming action to provide a strong electrical and mechanical connection between one or more contacts on a PCB and one or more corresponding contacts on a flexible substrate. This allows more complicated circuitry to be easily and effectively connected to an inexpensive and disposable printed sensor. The flexible substrate is clamped into position between the inner housing and the base of the outer housing.

Alternative embodiments make use of the similar clamping action; however, connection is made to one or more contacts that form part of the base of the outer housing. That is, one or more electrodes may be printed or otherwise deposited onto the base of the outer housing, and one or more electrodes of the inner housing may be urged against one or more corresponding electrodes of the outer housing as discussed herein. In other words, the substrate upon which the one or more electrodes/contacts are deposited/located may be integrated into the base of the outer housing (or vice versa). This can be advantageous where circuitry is printed or otherwise deposited onto a solid substrate.

For instance, circuitry (e.g. the interdigitated tracks discussed above) may be located on or in a solid object, such as furniture, with the outer housing being integrated into or secured on to the object itself. The PCB may therefore be connected to circuitry printed onto the object, and may be easily removed after use. This means that the circuitry in the PCB may be more easily and efficiently recycled using electronic recycling techniques, whilst the object itself can be recycled using traditional techniques.

Where connection is made to electrodes printed onto the base of the outer housing, the base itself may be a surface of a solid object (such as the underside of some furniture) whilst the jaws and side and rear walls of the outer housing may be secured to said surface, e.g. via screws or other securing means. Alternatively, the outer housing may be milled, cut away, moulded or otherwise formed out of the object itself.

Whilst the embodiments discussed above include two jaws, alternative embodiments make use of one or more jaws. Each jaw can be considered to be a biasing member forming a cavity for receiving a front end of the inner housing.

Whilst the above embodiments make use of one or more a resilient jaws, in alternative embodiments the one or more jaws are non-resilient. The wedge-shaped cavity within each jaw can still provide the downward force required to urge the contacts together as the inner housing is urged into each jaw. In this case the inner housing may be biased or otherwise continually urged into the one or more jaws, for instance, via one or more springs or other biasing members.

Alternatively, each jaw may be resilient; however, in this case each jaw need not form a wedge-shaped cavity. Instead, the upper surface of the cavity may run parallel to the base of the inner housing. In this case, the internal height of the jaw is less than the height of the front end of the inner housing. The resilience of the jaw provides a downward force as the inner housing is rotated into the jaw.

Whilst the above embodiments describe how the inner housing may be rotated into the one or more jaws, alternative embodiments make use of a linear sliding action. In this case, the opening of each jaw has a height that is larger than the height of front end of the inner housing. This allows the inner housing to be slid into the jaw before making contact with the downward sloping upper surface of the jaw which provides the downward clamping force.

The above embodiments describe the use of an inner housing for housing a PCB. This provides the advantage that the housing provides structural support to allow the contacts to be urged together without risk of breaking the PCB. Furthermore, the additional height provided by the housing increases the torsional force provided as the inner housing is rotated within the one or more jaws. Nevertheless, in alternative embodiments the PCB itself may be directly inserted into the one or more jaws to urge the one or more contacts of the PCB against one or more corresponding contacts on the substrate. Alternatively, the one or more contacts, and the corresponding circuitry of the PCB, may be integrated within the inner housing without the use of a PCB, for instance via soldering and wires.

While certain arrangements have been described, the arrangements have been presented by way of example only, and are not intended to limit the scope of protection as defined in the appended claims. The inventive concepts described herein may be implemented in a variety of other forms. In addition, various omissions, substitutions and changes to the specific implementations described herein may be made without departing from the scope of protection defined in the following claims.

## Claims

1. An electrical connector system (50) suitable for electrically connecting a first electrode to a second electrode printed onto a substrate (300), the system (50) comprising:
a male connector comprising the first electrode located proximal to a first end of the male connector; and
a female connector comprising:
a coupling portion forming a cavity with an opening into which the first end of the male connector may be received, the coupling portion having one or more biasing surfaces that each oppose a base (110) of the female connector; and
a housing formed by sidewalls (120) and a rear wall (130) into which the male connector is to be received, wherein:
the rear wall (130) opposes the coupling portion; and
each side wall (120) is connected to the rear wall (130) at corresponding corners;
wherein the electrical connector system (50) is configured such that when the male connector is urged into the coupling portion, the first electrode is urged towards the base (110) of the female connector by the one or more biasing surfaces to form an electrical connection between the first electrode and the second electrode positioned between the base (110) and the first end of the male connector;
wherein the system (50) is configured such that the first electrode is urged towards the base (110) of the female connector in response to the first end of the male connector being inserted into the coupling portion at an angle to the base (110) of the female connector and being rotated towards the base (110) of the female connector;
**characterized in that**:
a distance between the coupling portion and the rear wall (130) is substantially the same as a length of the male connector from the first end of the male connector to a second end of the male connector that is opposite to the first end.

2. The system (50) of claim 1 wherein each of the one or more biasing surfaces is angled relative to the base (110) such that the internal height of the cavity decreases from the opening towards a rear portion of the cavity.

3. The system (50) of claim 1 or claim 2 wherein the female connector comprises a substrate receiving section configured to receive the substrate (300) upon which the second electrode is printed and wherein the system (50) is configured to clamp the substrate (300) between the base (110) and the first electrode when the male connector is urged into the coupling portion.

4. The system (50) of claim 3 wherein the receiving section comprises a substrate holder (140) that is configured to receive and hold the substrate (300) in an interference fit prior to the male connector being received into the female connector.

5. The system (50) of any preceding claim wherein:
the second electrode is incorporated into a flexible strip for insertion between the base (110) and the first electrode; or
the base (110) forms part of the substrate (300) and wherein the second electrode is printed onto the base (110).

6. The system (50) of any preceding claim wherein the coupling portion is resilient and configured to be deflected at least partially when the first end is urged into the coupling portion thereby urging the first electrode against the base (110) of the female connector.

7. The system (50) of any preceding claim wherein the female connector comprises a releasable locking mechanism (160) configured to releasably secure the male connector into position in the female connector once the male connector has been urged into the coupling portion to secure the first electrode against the second electrode.

8. The system (50) of any preceding claim wherein for at least a portion of the cavity, the internal height of the cavity is less than a thickness of the first end of the male connector.

9. The system (50) of any preceding claim wherein the male connector comprises a sloped rear wall (214) located at the second end of the male connector and configured to contact the rear wall (130) of the female connector when the male connector is rotated towards the base (110) of the female connector to urge the male connector further into the coupling portion.

10. The system (50) of any proceeding claim wherein the first electrode of the male connector comprises two surfaces joined by an edge that is configured to contact the second electrode as the male connector is urged into the coupling portion.

11. The system (50) of any preceding claim wherein the first electrode is formed on a printed circuit board (210) housed within the male connector and exposed at least at the first electrode.

12. The system (50) of claim 11 wherein the male connector comprises a plurality of first electrodes formed on the printed circuit board (210), proximal to the first end of the male connector, wherein solder resist has been removed from between the contacts to improve connection with one or more corresponding second electrodes positioned between the base (110) and the first end of the male connector.

13. The system (50) of any proceeding claim wherein the male connector comprises one or more indentations for receiving one or more protrusions from the coupling portion.

## Patentansprüche

1. Elektrisches Steckverbindersystem (50), zum elektrischen Verbinden einer ersten Elektrode mit einer zweiten Elektrode, die auf ein Substrat (300) gedruckt ist, wobei das System (50) Folgendes umfasst:
einen Stecker, der die erste Elektrode umfasst, die sich in der Nähe eines ersten Endes des Steckers befindet; und
eine Steckbuchse, Folgendes umfassend:
einen Kupplungsabschnitt, der einen Hohlraum mit einer Öffnung bildet, in der das erste Ende des Steckers aufgenommen werden kann, wobei der Kupplungsabschnitt eine oder mehrere Vorspannflächen aufweist, die jeweils einer Basis (110) der Steckbuchse gegenüberliegen; und
ein Gehäuse, das von Seitenwänden (120) und einer Rückwand (130) gebildet ist, in dem der Stecker aufgenommen werden soll, wobei:
die Rückwand (130) dem Kupplungsabschnitt gegenüberliegt; und
jede Seitenwand (120) mit der Rückwand (130) an entsprechenden Ecken verbunden ist,
wobei das elektrische Steckverbindersystem (50) so konfiguriert ist, dass, wenn der Stecker in den Kupplungsabschnitt gedrückt wird, die erste Elektrode durch die eine oder mehreren Vorspannflächen in Richtung der Basis (110) der Steckbuchse gedrückt wird, um eine elektrische Verbindung zwischen der ersten Elektrode und der zweiten Elektrode zu bilden, die zwischen der Basis (110) und dem ersten Ende des Steckers positioniert ist,
wobei das System (50) derart konfiguriert ist, dass die erste Elektrode in Richtung der Basis (110) der Steckbuchse gedrückt wird, als Reaktion darauf, dass das erste Ende des Steckers in den Kupplungsabschnitt in einem Winkel zur Basis (110) der Steckbuchse eingeführt wird und in Richtung der Basis (110) der Steckbuchse gedreht wird,
**dadurch gekennzeichnet, dass**:
ein Abstand zwischen dem Kupplungsabschnitt und der Rückwand (130) im Wesentlichen gleich einer Länge des Steckers von dem ersten Ende des Steckers bis zu einem zweiten Ende des Steckers ist, das dem ersten Ende gegenüberliegt.

2. System (50) nach Anspruch 1, wobei jede der einen oder mehreren Vorspannflächen relativ zur Basis (110) so abgewinkelt ist, dass die Innenhöhe des Hohlraums von der Öffnung zu einem hinteren Abschnitt des Hohlraums hin abnimmt.

3. System (50) nach Anspruch 1 oder 2, wobei die Steckbuchse einen Substrataufnahmeabschnitt umfasst, der derart konfiguriert ist, dass er das Substrat (300) aufnimmt, auf das die zweite Elektrode gedruckt ist, und wobei das System (50) so konfiguriert ist, dass es das Substrat (300) zwischen der Basis (110) und der ersten Elektrode einklemmt, wenn der Stecker in den Kupplungsabschnitt gedrückt wird.

4. System (50) nach Anspruch 3, wobei der Aufnahmeabschnitt einen Substrathalter (140) umfasst, der so konfiguriert ist, dass er das Substrat (300) in einer Presspassung aufnimmt und hält, bevor der Stecker in die Steckbuchse aufgenommen wird.

5. System (50) nach einem der vorhergehenden Ansprüche, wobei:
die zweite Elektrode in einen flexiblen Streifen integriert ist, der zwischen der Basis (110) und der ersten Elektrode eingeführt wird, oder
die Basis (110) einen Teil des Substrats (300) bildet und wobei die zweite Elektrode auf die Basis (110) gedruckt ist.

6. System (50) nach einem der vorhergehenden Ansprüche, wobei der Kupplungsabschnitt elastisch und derart konfiguriert ist, dass er zumindest teilweise ausgelenkt wird, wenn das erste Ende in den Kupplungsabschnitt gedrückt wird, wodurch die erste Elektrode gegen die Basis (110) der Steckbuchse gedrückt wird.

7. System (50) nach einem der vorhergehenden Ansprüche, wobei die Steckbuchse einen lösbaren Verriegelungsmechanismus (160) umfasst, der derart konfiguriert ist, dass er den Stecker lösbar in der Buchse in einer Position sichert, sobald der Stecker in den Kupplungsabschnitt gedrückt wurde, um die erste Elektrode gegen die zweite Elektrode zu sichern.

8. System (50) nach einem der vorhergehenden Ansprüche, wobei für mindestens einen Abschnitt des Hohlraums die Innenhöhe des Hohlraumes geringer ist als eine Dicke des ersten Endes des Steckers.

9. System (50) nach einem der vorhergehenden Ansprüche, wobei der Stecker eine schräge Rückwand (214) umfasst, die sich am zweiten Ende des Steckers befindet und derart konfiguriert ist, dass sie die Rückwand (130) der Steckbuchse berührt, wenn der Stecker in Richtung der Basis (110) der Steckbuchse gedreht wird, um den Stecker weiter in den Kupplungsabschnitt zu drücken.

10. System (50) nach einem der vorhergehenden Ansprüche, wobei die erste Elektrode des Steckers zwei Oberflächen umfasst, die durch eine Kante verbunden sind, die konfiguriert ist, um die zweite Elektrode zu berühren, wenn der Stecker in den Kupplungsabschnitt gedrückt wird.

11. System (50) nach einem der vorhergehenden Ansprüche, wobei die erste Elektrode auf einer gedruckten Leiterplatte (210) gebildet ist, die in dem Stecker untergebracht ist und zumindest an der ersten Elektrode freiliegt.

12. System (50) nach Anspruch 11, wobei der Stecker eine Vielzahl von ersten Elektroden umfasst, die auf der gedruckten Leiterplatte (210) in der Nähe des ersten Endes des Steckers ausgebildet sind, wobei Lötstopplack zwischen den Kontakten entfernt wurde, um die Verbindung mit einer oder mehreren entsprechenden zweiten Elektroden zu verbessern, die zwischen der Basis (110) und dem ersten Ende des Steckers positioniert sind.

13. System (50) nach einem der vorhergehenden Ansprüche, wobei der Stecker eine oder mehrere Vertiefungen zum Aufnehmen eines oder mehrerer Vorsprünge aus dem Kupplungsabschnitt umfasst.

## Revendications

1. Système de connecteur électrique (50) adapté pour connecter électriquement une première électrode à une deuxième électrode imprimée sur un substrat (300), le système (50) comprenant :
un connecteur mâle comprenant la première électrode située à proximité d'une première extrémité du connecteur mâle ; et
un connecteur femelle comprenant :
une partie de couplage formant une cavité avec une ouverture dans laquelle la première extrémité du connecteur mâle peut être reçue, la partie de couplage comportant une ou plusieurs surfaces de sollicitation qui s'opposent chacune à une base (110) du connecteur femelle ; et
un boîtier formé par des parois latérales (120) et une paroi arrière (130) dans lequel le connecteur mâle doit être reçu, dans lequel :
la paroi arrière (130) est opposée à la partie de couplage ; et
chaque paroi latérale (120) est reliée à la paroi arrière (130) à des coins correspondants ;
dans lequel le système de connecteur électrique (50) est configuré de telle manière que lorsque le connecteur mâle est poussé dans la partie de couplage, la première électrode est poussée vers la base (110) du connecteur femelle par l'une ou les plusieurs surfaces de sollicitation pour former une connexion électrique entre la première électrode et la deuxième électrode positionnée entre la base (110) et la première extrémité du connecteur mâle ;
dans lequel le système (50) est configuré de telle manière que la première électrode est poussée vers la base (110) du connecteur femelle en réaction à une insertion de la première extrémité du connecteur mâle dans la partie de couplage selon un angle par rapport à la base (110) du connecteur femelle et sa rotation vers la base (110) du connecteur femelle ;
**caractérisé en ce que** :
une distance entre la partie de couplage et la paroi arrière (130) est sensiblement égale à une longueur du connecteur mâle de la première extrémité du connecteur mâle à une deuxième extrémité du connecteur mâle opposée à la première extrémité.

2. Système (50) selon la revendication 1, dans lequel chacune de l'une ou les plusieurs surfaces de sollicitation est inclinée par rapport à la base (110) de telle manière que la hauteur intérieure de la cavité décroît de l'ouverture vers une partie arrière de la cavité.

3. Système (50) selon la revendication 1 ou 2, dans lequel le connecteur femelle comprend une section de réception de substrat configurée pour recevoir le substrat (300) sur lequel la deuxième électrode est imprimée et dans lequel le système (50) est configuré pour serrer le substrat (300) entre la base (110) et la première électrode lorsque le connecteur mâle est poussé dans la partie de couplage.

4. Système (50) selon la revendication 3, dans lequel la section de réception comprend un porte-substrat (140) qui est configuré pour recevoir et maintenir le substrat (300) dans un ajustement serré avant que le connecteur mâle ne soit reçu dans le connecteur femelle.

5. Système (50) selon l'une quelconque des revendications précédentes, dans lequel :
la deuxième électrode est incorporée dans un ruban flexible destiné à être inséré entre la base (110) et la première électrode ; ou
la base (110) forme une partie du substrat (300) et dans lequel la deuxième électrode est imprimée sur la base (110).

6. Système (50) selon l'une quelconque des revendications précédentes, dans lequel la partie de couplage est résiliente et configurée pour être déviée au moins en partie lorsque la première extrémité est poussée dans la partie de couplage en poussant ainsi la première électrode contre la base (110) du connecteur femelle.

7. Système (50) selon l'une quelconque des revendications précédentes, dans lequel le connecteur femelle comprend un mécanisme de verrouillage amovible (160) configuré pour fixer de façon amovible le connecteur mâle en position dans le connecteur femelle une fois que le connecteur mâle a été poussé dans la partie de couplage pour fixer la première électrode contre la deuxième électrode.

8. Système (50) selon l'une quelconque des revendications précédentes, dans lequel, pour au moins une partie de la cavité, la hauteur intérieure de la cavité est inférieure à une épaisseur de la première extrémité du connecteur mâle.

9. Système (50) selon l'une quelconque des revendications précédentes, dans lequel le connecteur mâle comprend une paroi arrière inclinée (214) située à la deuxième extrémité du connecteur mâle et configurée pour entrer en contact avec la paroi arrière (130) du connecteur femelle lorsque le connecteur mâle est tourné vers la base (110) du connecteur femelle pour pousser davantage le connecteur mâle dans la partie de couplage.

10. Système (50) selon l'une quelconque des revendications précédentes, dans lequel la première électrode du connecteur mâle comprend deux surfaces reliées par un rebord qui est configuré pour entrer en contact avec la deuxième électrode lorsque le connecteur mâle est poussé dans la partie de couplage.

11. Système (50) selon l'une quelconque des revendications précédentes, dans lequel la première électrode est formée sur une carte à circuit imprimé (210) logée à l'intérieur du connecteur mâle et exposée à au moins la première électrode.

12. Système (50) selon la revendication 11, dans lequel le connecteur mâle comprend une pluralité de premières électrodes formées sur la carte à circuit imprimé (210), à proximité de la première extrémité du connecteur mâle, dans lequel une -épargne de soudage a été enlevée entre les contacts pour améliorer une connexion avec une ou plusieurs deuxièmes électrodes correspondantes positionnées entre la base (110) et la première extrémité du connecteur mâle.

13. Système (50) selon l'une quelconque des revendications précédentes, dans lequel le connecteur mâle comprend une ou plusieurs encoches pour recevoir une ou plusieurs parties saillantes de la partie de couplage.
